# EUROPÄISCHE PATENTANMELDUNG

(11) **EP 0 578 991 A1**
(43) Veröffentlichungstag der Anmeldung: **19.01.1994**
(21) Anmeldenummer: 93109752.1
(22) Anmeldetag: 18.06.1993
(51) Int. Cl.: H01L 25/07

(54) **Bidirektionaler Halbleiterschalter**

(30) Priorität: 13.07.1992 DE 4222973
(71) Anmelder: ASEA BROWN BOVERI AG, CH-5401 Baden (CH)
(72) Erfinder: Stockmeier, Thomas, Dr., CH-5405 Baden-Dättwil (CH)
(74) Vertreter: Lück, Gert, Dr.

(57) **Zusammenfassung**

Bei einem bidirektionalen, ein- und ausschaltbaren Halbleiterschalter sind auf einer Grundplatte (9) Leiterbahnen aufgebracht, welche die Hauptanschlüsse (1, 2) und die Steueranschlüsse (3, 4) bilden. Auf den Leiterbahnen, welche die Hauptanschlüsse bilden (1, 2) sind mindestens zwei ein- und ausschaltbare, rückwärtssperrende Halbleiterbauelemente (5a-h) angebracht. Die Steuerelektroden (8a-h) und die zweiten Hauptelektroden (7a-h) der Halbleiterbauelemente (5a-h)
sind so verschaltet, dass der Halbleiterschalter die geforderte bidirektionale Schaltfunktion aufweist.

## Beschreibung

### Technisches Gebiet

Die Erfindung bezieht sich auf das Gebiet der Leistungselektronik. Sie betrifft einen bidirektionalen Halbleiterschalter nach dem Oberbegriff des ersten Anspruchs.

### Stand der Technik

Ein solcher bidirektionaler Halbleiterschalter wird schon in der Deutschen Offenlegungsschrift DE 40 11 509 beschrieben.

Auf dem Gebiet der Leistungselektronik wurden in den letzten Jahren moderne Umrichterkonzepte für industrielle Antriebe vorgestellt (siehe dazu z.B. T.A. Lipo, IEEE Transactions on Power Electronics, Vol. 13, No. 2, April 1988, S. 105-117). Für die Realisierung dieser Umrichterschaltungen (z.B. der im Artikel von Lipo erwähnte Matrixkonverter) werden aber Bauelemente benötigt, welche eine bidirektionale Leit- und Sperrfähigkeit besitzen. Durch die Anwendung von solchen Bauelementen, welche in zwei Richtungen ein- und ausschaltbar sind, kann die sonst benötigte Freilauf-Diode eingespart und auf Schutzelemente weitgehend verzichtet werden.

In der oben erwähnten Schweizerischen Patentschrift (CH 1491/89-8) wird die bidirektionale Schaltfunktion durch ein Bauteil erreicht, das auf der Vorder- und auf der Rückseite Steuerelektroden aufweist. Es handelt sich dabei um einen Thyristor mit doppelseitigen, MOS-gesteuerten Kurzschlüssen, welche die bidirektionale Sperr- und Leitfähigkeit gewährleisten.

Ein Bauelement, welches auf beiden Seiten Steuerelektroden aufweist, stellt aber nicht nur an den Herstellungsprozess hohe Anforderungen, sondern auch die Kühlung und die Integration des Bauteils in ein Gehäuse sind problematisch. Solche Bauelemente sind dementsprechend auch sehr teuer.

### Darstellung der Erfindung

Aufgabe der vorliegenden Erfindung ist es nun, einen bidirektionalen Halbleiterschalter anzugeben, welcher im Gegensatz zum Stand der Technik einfach realisierbar ist und sich durch niedrige Herstellungskosten und einfache Kühlungsmöglichkeit auszeichnet.

Diese Aufgabe wird durch die Merkmale des ersten Anspruchs gelöst.

Der Kern der Erfindung besteht insbesondere darin, dass die bidirektionale Schaltfunktion hybrid realisiert wird. Mindestens zwei ein- und ausschaltbare, rückwartsleitende Halbleiterbauelemente werden zu diesem Zweck mit ihrer ersten Hauptfläche bzw. Hauptelektrode auf die Leiterbahnen gelötet. Die Steuerelektroden bzw. die zweiten Hauptelektroden der Halbleiterbauelemente werden so mit den Steueranschlüssen bzw. den Hauptanschlüssen verschaltet, dass der Halbleiterschalter eine bidirektionale Schaltfunktion aufweist.

Bevorzugte Ausführungsformen der Erfindung werden in den Unteransprüchen offenbart.

Der Vorteil des erfindungsgemässen Aufbaus besteht darin, dass Bauelemente nach dem heutigen Wissensstand verwendet werden können. Der Schalter ist deshalb einfach zu realisieren, weist niedrigere Herstellungskosten auf und stellt auch weniger hohe Anforderungen an die Kühlungstechnik. Da der erfindungsgemässe Schalter nur auf einer Seite Steuerelektroden aufweist, kann die Kühlung wesentlich einfacher aufgebaut sein und der Halbleiterschalter kann problemlos in ein Gehäuse integriert werden. Insgesamt tragen diese Vorteile zu einer erhöhten Zuverlässigkeit des bidirektionalen Schalters bei.

### Kurze Beschreibung der Zeichnungen

Nachfolgend wir die Erfindung anhand von Ausführungsbeispielen im Zusammenhang mit den Zeichnungen näher erläutert.

Es zeigen:
- **Fig. 1**: Eine Draufsicht eines erfindungsgemässen bidirektionalen Halbleiterschalters,
- **Fig. 2**: Einen Schnitt durch einen erfindungsgemässen Halbleiterschalter entlang der Strecke x-x.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

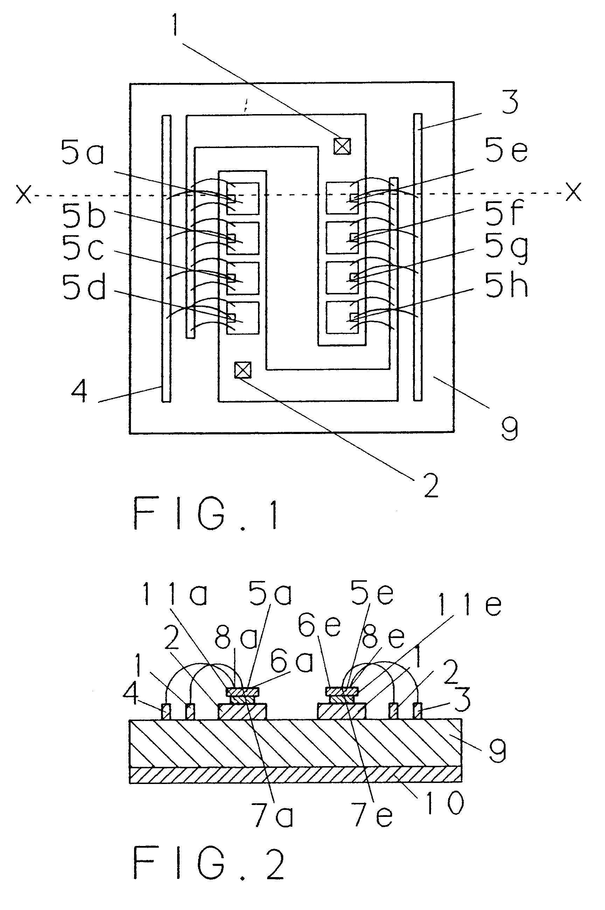

**Figur 1** zeigt eine Draufsicht eines erfindungsgemässen, bidirektionalen Halbleiterschalters. Dieser Schalter umfasst zwei Hauptanschlüsse (1, 2), durch welche der zu schaltende Strom fliesst, sowie zwei steueranschlüsse (3, 4) und ein Anzahl Halbleiterbauelemente (5a-5h). Die Halbleiterbauelemente (5a-5h) bestehen aus einer Anzahl unterschiedlich dotierter Siliziumschichten. Diese Schichten werden durch eine erste und eine zweite Hauptfläche (6a-h) begrenzt. Die erste Hauptfläche weist eine erste Hauptelektrode (i.a. die Anode), die zweite Hauptfläche (6a-h) eine zweite Hauptelektrode (7a-h) (i.a. die Kathode) und eine Steuerelektrode (8a-h) auf. Die Halbleiterbauelemente (5a-5h) sind rückwärtssperrende Halbleiterschalter, vorzugsweise mit einer MOS-gesteuerten Struktur wie MCT, IGBT oder MOSFET, welche über die Steuerelektrode (8a-h) ein- bzw. ausgeschaltet werden können.

Auf einer Grundplatte (9), welche vorzugsweise aus DCB-Keramik besteht, sind Leiterbahnen so angebracht, dass sie die erwähnten Hauptanschlüsse (1, 2) und die Steueranschlüsse (3, 4) bilden. Für das Anbringen der Leiterbahnen werden die für die Behandlung von DCB-Keramik üblichen Methoden verwendet. Die Leiterbahnen der Hauptanschlüsse (1, 2) bilden beispielsweise zwei ineinander greifende "U", deren innere Schenkel breiter sind. Parallel zum äusseren, dünneren Schenkel verläuft die Leiterbahn des ersten bzw. zweiten Steueranschlusses.

Mindestens zwei Halbleiterbauelemente (5a, 5e) werden mit ihrer ersten Hauptfläche auf die Grundplatte aufgebracht, derart, dass die ersten Hauptelektroden mit dem ersten Hauptanschluss (1) bzw. dem zweiten Hauptanschluss (2) in elektrischer Verbindung stehen. Die zweiten Hauptelektroden (7a, 7e) werden nun mit den Hauptanschlüssen (1, 2) und die Steuerelektroden (8a, 8e) mit den Steueranschlüssen (3, 4) so verschaltet, dass der resultierende Halbleiterschalter eine bidirektionale Schaltfunktion aufweist.

Um die bidirektionale Schaltfunktion zu erhalten, wird die zweite Hauptelektrode (7e) desjenigen Halbleiterbauelements (5e), dessen erste Hauptelektrode mit dem ersten Hauptanschluss (1) in Verbindung steht, mit dem zweiten Hauptanschluss (2) verbunden. Die steuerelektrode (8e) desselben Halbleiterbauelements (5e) wird mit dem ersten Steueranschluss (3) verbunden. Die zweite Hauptelektrode (7a) desjenigen Halbleiterbauelements (5a), dessen erste Hauptelektrode mit dem zweiten Hauptanschluss (2) in Verbindung steht, wird mit dem ersten Hauptanschluss (1) verbunden, und die Steuerelektrode (8a) desselben Halbleiterbauelements (5a) wird mit dem zweiten Steueranschluss (4) verbunden. Als Verbindungstechnik kommt vorzugsweise die Wire-Bonding-Technik oder die Foil-Clip-Technik zur Anwendung. Selbstverständlich ist die Erfindung aber nicht auf diese beiden Techniken beschränkt, sondern jede Verbindungstechnik, welche für die hybride Realisierung eines solchen Halbleiterschalters geeignet ist, kann angewendet werden.

Anhand von beispielhaften Situationen soll im folgenden die Funktion des erfindungsgemässen Halbleiterschalters erläutert werden.

Die Halbleiterbauelemente stellen ein Stromventil dar, welches nur in einer Richtung Strom leiten kann und ein-bzw. ausschaltbar ist. Je zwei dieser Ventile sind antiparallel geschaltet.

In einer ersten Situation soll der Strom vom ersten Hauptanschluss (1) zum zweiten Hauptanschluss (2) fliessen. Dazu wird das Halbleiterbauelement (5e) über einen entsprechendes Steuersignal am ersten Steueranschluss (3) eingeschaltet und damit in den leitenden Zustand versetzt. Das Halbleiterbauelement (5a) wird über ein entsprechendes Steuersignal am zweiten Steueranschluss (4) ausgeschaltet bzw. bleibt ausgeschaltet, da die Halbleiterbauelemente ja rückwärtssperrend sind. Der Strom fliesst in dieser Situation vom ersten Hauptanschluss (1) über die erste Hauptelektrode des Halbleiterbauelements (5e) zur zweiten Hauptelektrode (7e) und von dort über die Wire-Bond-Drähte zum zweiten Hauptanschluss (2). Der Strompfad erster Hauptanschluss (1) - erste Hauptelektrode des Halbleiterbauelements (5a) - zweite Hauptelektrode (7a) - Wire-Bond-Drähte - zweiter Hauptanschluss (2) ist gesperrt, da das zweite Halbleiterbauelement (5a) sperrt.

Für den Fall, dass der Strom vom zweiten Hauptanschluss (2) zum ersten Hauptanschluss (1) fliessen soll, übernimmt das Halbleiterbauelement (5a) die Aufgabe des leitenden Schalters und das Halbleiterbauelement (5e) diejenige des sperrenden Schalters. Die Steuersignale sind dementsprechend anzupassen.

Für den Fall, dass gar kein Strom fliessen soll, werden beide Halbleiterbauelemente (5a, 5e) mit entsprechenden Steuersignalen ausgeschaltet. Damit sind beide Strompfade gesperrt, ein Strom kann nicht fliessen.

Bis jetzt war der Einfachheit halber immer die Rede von nur zwei Halbleiterbauelementen (5a, 5e). Bevorzugterweise werden aber mehrere Halbleiterbauelemente parallel eingesetzt, wie es in der Figur 1 am Beispiel von 8 Bauelementen dargestellt ist. In der oben erläuterten Funktionsweise ist dazu das Halbleiterbauelement (5a) durch die Gruppe (5a-d) bzw. (5e) durch (5e-h) zu ersetzen. Die Anzahl Bauelemente ist jedoch nach oben offen.

**Figur 2** zeigt einen Schnitt durch einen Halbleiterschalter entlang der Strecke x-x und stellt dar, wie die Halbleiterbauelemente (5a-h) auf die Leiterbahnen aufgebracht werden.

Die Halbleiterbauelemente (5a, 5e) sind auf eine Kontaktplatte (11a, 11e) gelötet, welche ihrerseits auf die Leiterbahn (2 bzw. 1) gelötet wird. Die Kontaktplatte (11a, 11e) steht in elektrischer Verbindung mit der ersten Hauptelektrode des Halbleiterbauelements. Der Abstand der ersten Hauptfläche der Halbleiterbauelements (5a bzw. 5e) und zur Leiterbahn (1 bzw. 2) muss so gewählt werden, dass ein Durchschlagen der Spannung, welche zwischen der Leiterbahn und dem Halbleiterbauelement anliegt, falls das Bauelement sperrt, verhindert wird. Da die Grundplatte aus DCB-Keramik besteht, weist sie auf der Unterseite eine Kupferschicht (10) auf.

Insgesamt steht also mit der Erfindung ein bidirektionaler Halbleiterschalter zur Verfügung, welcher aus handelsüblichen Bauelementen aufgebaut ist und sich besonders durch eine hohe Zuverlässigkeit, bedingt durch einfache Realisierbarkeit, effektive und einfache Kühlung sowie einfache Verbindungstechnik, auszeichnet und welcher darüberhinaus auch kostengünstig hergestellt werden kann.

### Bezeichnungsliste

- 1: erster Hauptanschluss
- 2: zweiter Hauptanschluss
- 3: erster Steueranschluss
- 4: zweiter Steueranschluss
- 5a-h: Halbleiterbauelemente
- 6a-h: zweite Hauptfläche
- 7a-h: zweite Hauptelektrode
- 8a-h: Steuerelektrode
- 9: Grundplatte
- 10: Cu-Schicht
- 11: Kontaktplatte

## Patentansprüche

1. Bidirektionaler Halbleiterschalter umfassend
a) einen ersten Hauptanschluss (1), einen zweiten Hauptanschluss (2) und zwei Steueranschlüsse (3, 4);
b) ein- und ausschaltbare Halbleiterbauelemente (5a-h), welche ein Halbleitersubstrat umfassen, welches durch zwei Hauptflächen begrenzt ist und zwischen den Hauptflachen eine Mehrzahl unterschiedlich dotierter Silizium-Schichten aufweist, wobei
c) die erste Hauptfläche eine erste Hauptelektrode und die zweite Hauptfläche eine zweite Hauptelektrode und eine Steuerelektrode aufweist;
dadurch gekennzeichnet, dass
d) auf einer Grundplatte (9) eine Anzahl Leiterbahnen so aufgebracht sind, dass die Leiterbahnen die beiden Hauptanschlüsse (1,2) und die beiden Steueranschlüsse (3,4) bilden;
e) die Halbleiterbauelemente (5a-h) rückwärtssperrend sind, und
f) mindestens zwei Halbleiterbauelemente (5a, 5e) mit ihrer ersten Hauptflächen auf der Grundplatte (9) angebracht sind, wobei
g) bei der einen Hälfte der Halbleiterbauelemente (5e-h) die erste Hauptelektrode mit dem ersten Hauptanschluss (1), bei der anderen Hälfte (5a-d) die erste Hauptelektrode mit dem zweiten Hauptanschluss (2) in Verbindung steht, und
h) die zweiten Hauptelektroden (7a-h) mit den Hauptanschlüssen (1,2) und die Steuerelektroden (8a-h) mit den Steueranschlüssen so verschaltet sind, dass der Halbleiterschalter eine bidirektionale Schaltfunktion aufweist.

2. Bidirektionaler Halbleiterschalter nach Anspruch 1, dadurch gekennzeichnet, dass
a) die zweiten Hauptelektroden (7e-h) derjenigen Halbleiterbauelemente (5e-h), deren erste Hauptelektrode mit dem ersten Hauptanschluss (1) in Verbindung stehen, mit dem zweiten Hauptanschluss (2) verbunden sind, und die steuerelektroden (8e-h) derselben Halbleiterbauelemente (5e-h) mit dem ersten Steueranschluss (3) verbunden sind, sowie
b) die zweiten Hauptelektroden (7a-d) derjenigen Halbleiterbauelemente (5a-d), deren erste Hauptelektrode mit dem zweiten Hauptanschluss (2) in Verbindung steht, mit dem ersten Hauptanschluss (1) verbunden sind, und die Steuerelektroden (8a-d) derselben Halbleiterbauelemente (5a-d) mit dem zweiten Steueranschluss (4) verbunden sind.

3. Bidirektionaler Halbleiterschalter nach Anspruch 1 oder 2, dadurch gekennzeichnet, dass die Grundplatte (9) aus Direct-Copper-Bonding-Keramik besteht.

4. Bidirektionaler Halbleiterschalter nach Anspruch 3, dadurch gekennzeichnet, dass die Verbindung der zweiten Hauptelektroden (7a-h) mit den jeweiligen Hauptanschlüssen (1, 2) bzw. der Steuerelektroden (8a-h) mit ihren Steueranschlüssen (3,4) mittels Wire-Bonding-Technik erfolgt.

5. Bidirektionaler Halbleiterschalter nach Anspruch 3, dadurch gekennzeichnet, dass die Verbindung der zweiten Hauptelektroden (7a-h) mit den jeweiligen Hauptanschlüssen (1, 2) bzw. der Steuerelektroden (8a-h) mit ihren Steueranschlüssen (3,4) mittels Foil-Clip-Technik erfolgt.

6. Bidirektionaler Halbleiterschalter nach einem der vorangehenden Ansprüche, dadurch gekennzeichnet, dass zwischen den Halbleiterbauelementen (5a-h) und der Grundplatte (9) eine Kontaktplatte (11a-h) vorhanden ist, auf welche die Halbleiterbauelemente (5a-h) mit ihrer ersten Hauptfläche aufgelötet sind, wobei die Kontaktplatte (11a-h) ihrerseits auf die Grundplatte (9) gelötet ist.

7. Bidirektionaler Halbleiterschalter nach einem der vorangehenden Ansprüche, dadurch gekennzeichnet, dass die Halbleiterbauelemente (5a-h) MOS-gesteuerte Strukturen, insbesondere MCT-, IGBT- oder MOSFET-Strukturen, aufweisen.

8. Bidirektionaler Halbleiterschalter nach einem der vorangehenden Ansprüche, dadurch gekennzeichnet, dass die Grundplatte (9) in ein Gehäuse eingesetzt ist, welches mit Kunststoff vergossen ist, wobei der erste und zweite Hauptanschluss sowie die Steueranschlüsse herausgeführt sind.
